(19) Europäisches Patentamt
European Patent Office
Office européen des brevets

(11) **EP 4 165 719 B1**

(12) **FASCICULE DE BREVET EUROPEEN**

(45) Date de publication et mention de la délivrance du brevet:
**15.07.2026 Bulletin 2026/29**

(21) Numéro de dépôt: **21755693.5**

(22) Date de dépôt: **09.06.2021**

(51) Classification Internationale des Brevets (IPC):
**H01P 5/107** (2006.01)    **H03F 3/60** (2006.01)

(52) Classification Coopérative des Brevets (CPC):
**H01P 5/107; H03F 3/60**

(86) Numéro de dépôt international:
**PCT/EP2021/065507**

(87) Numéro de publication internationale:
**WO 2021/250117 (16.12.2021 Gazette 2021/50)**

(54) **AMPLIFICATEUR HYPERFREQUENCES DE PUISSANCE A ETAT SOLIDE ET COMBINEUR DE PUISSANCE COMPRENANT QUATRE TELS AMPLIFICATEURS A ETAT SOLIDE**

HYPERFREQUENZ-FESTKÖRPERVERSTÄRKER UND LEISTUNGSKOMBINIERER MIT VIER SOLCHEN FESTKÖRPERVERSTÄRKERN

SOLID-STATE HYPERFREQUENCY AMPLIFIER AND POWER COMBINER COMPRISING FOUR SUCH SOLID-STATE AMPLIFIERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.06.2020 FR 2006096**

(43) Date de publication de la demande:
**19.04.2023 Bulletin 2023/16**

(73) Titulaire: **THALES**
**92190 Meudon (FR)**

(72) Inventeurs:
• **BELLUOT, James**
**78000 VERSAILLES (FR)**
• **GERFAULT, Bertrand**
**78350 JOUY EN JOSAS (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**EP-A1- 0 074 613**    **EP-A1- 2 201 679**
**EP-B1- 2 201 679**    **US-A- 4 458 222**
**US-A1- 2017 104 258**

**Description**

L'invention porte sur un amplificateur hyperfréquences de puissance à état solide et combineur de puissance comprenant quatre tels amplificateurs à état solide.

L'invention se situe dans le domaine des amplificateurs hyperfréquences de puissance à état solide ou SSPA pour acronyme de "Solid State Power Amplifier" en langue anglaise.

Il est connu des systèmes d'amplification, tels des SSPA et des tubes à ondes progressives ou TWTA pour acronyme de "Traveling-Wave Tube Amplifier" en langue anglaise, à combinaison spatiale ou classique présentant toutes des inconvénients majeurs.

En effet, ces systèmes d'amplification présentent des problèmes de compacité, de rendement, de réparation, de maintenabilité, d'assemblage, de coût d'assemblage et d'évolution, d'évolutivité et de limitation en puissance.

Il est connu des amplificateurs à tube ou tubes à ondes progressives TWTA qui utilisent un filament chauffé, produisant une libération d'électrons par émission thermo-ionique. Ces électrons sont ensuite accélérés dans le vide par le biais d'un champ électrique de forte intensité généré par une très haute tension THT. Une fois accélérés, ces électrons sont focalisés dans un faisceau qui interagit avec une onde hyperfréquence. Progressivement, l'énergie continue, ou DC pour acronyme de "Direct Current" en langue anglaise, contenue dans le faisceau d'électrons est peu à peu convertie en énergie hyperfréquences à mesure que les électrons parcourent la ligne d'interaction. Cette énergie est alors transmise en dehors du tube alors que le résiduel d'énergie est transmis au collecteur et dissipé sous forme de chaleur.

Ces amplificateurs sont très compacts et fonctionnent à haut rendement, mais en tout ou rien, et en cas de panne, les produits sont hors d'usage. Ils nécessitent une très haute tension THT, une haute technicité, sont très onéreux à produire, et très difficiles à maintenir.

Il est connu le document EP 2 201 679 A1 qui divulgue un système d'interface entre circuit imprimé et guide d'onde avec une vis de réglage pour ajuster les dimensions de la cavité d'interface.

Il est également connu le document EP 0 074 613 A1 qui divulgue une transition utilisant un ruban métallique interposé entre l'arête du guide d'onde et la ligne de propagation.

Il est également connu le document US 4 458 222 A qui divulgue un couplage capacitif utilisant un film diélectrique entre l'arête et la ligne de propagation.

Il est également connu des amplificateurs à état solide SSPA monolithiques combinés spatialement par le biais de lignes antipodales de type Vivaldi qui rayonneront ensuite dans des cavités.

Ces cavités constituent les points d'entrées d'un combineur à cavité conique. Ce type d'amplificateur, par exemple décrit dans le document US 10 340 574 B2, présentent une bonne compacité, des pertes assez faibles, et une absence de problèmes d'interconnexions inter-étages. Cependant, ils présentent une combinaison radiale qui rend très complexe la gestion de la dissipation thermique quasi impossible le fonctionnement de manière optimale en mode pulsé car les capacités de réserve d'énergie ne peuvent être placées au plus proche des circuits intégrés monolithiques hyperfréquences ou MMIC pour acronyme de "Monolithic Microwave Integrated Circuit" en langue anglaise.

Il est également connu des amplificateurs à état solide SSPA en combinaison hybride ou en T, dans lesquels des circuits intégrés monolithiques hyperfréquences MMIC sont combinés par le biais de coupleurs hybrides, wilkinson ou jonctions en T.

De tels amplificateurs sont relativement peu onéreux, mais présentent cependant des pertes relativement élevées, une absence d'évolutivité (limitation en puissance), une réparabilité très difficile du fait de l'assemblage type puce et fils ou "chip and wire" en langue anglaise.

Aucune des solutions existantes mentionnées précédemment n'est donc satisfaisante car elles présentent toutes des défauts majeurs.

Il est également connu le document EP0074613A1 qui utilise une liaison ruban, comme illustré sur la figure 1 en référence 28. Ce mode de réalisation utilise la fonction d'alimentation par l'arête ou "ridge" en langue anglaise, comme illustré sur la figure 1 correspondant à la figure 3B du document EP0074613A1 avec les références 24, 25, 26 et 27. Cette liaison ruban présente l'avantage d'être souple mais ne permet pas de réparation simple car la mise en œuvre d'un tel ruban nécessite un retour usine et des machines spécifiques.

Un but de l'invention est de pallier les problèmes précédemment cités, et notamment faciliter la réparabilité, la compacité et l'évolutivité.

Aussi, il est proposé, selon un aspect de l'invention, un amplificateur hyperfréquences de puissance à état solide comprenant une partie supérieure d'un guide d'onde, une arête de guide d'onde à transformation d'impédance linéarisée, une partie inférieure du guide d'onde, une ligne de propagation, et au moins une interconnexion, entre la ligne de propagation et l'arête de guide d'onde à transformation d'impédance linéarisée, ou "linearized impedance matching waveguide ridge" en langue anglaise, munie d'un dispositif de serrage garantissant un contact direct entre l'arête et la ligne de propagation, dans lequel le dispositif de serrage comprend au moins une vis de pression et un raidisseur support de pression, la vis de pression exerçant une force sur la ligne de propagation via le raidisseur pour maintenir le contact direct.

Un tel système permet d'améliorer la réparabilité, la compacité et l'évolutivité.

Ainsi, le système à raidisseur conférera au dispositif de pression une élasticité qui garantira l'absence de déformation et la vis de pression à embout plat ne perforera pas la matière solidaire de l'arête.

Ainsi, le serrage de cette vis permet de contraindre l'arête du guide et de maintenir son extrémité en contact de la ligne de propagation sur circuit imprimé, offrant ainsi une liaison souple et facilement réparable.

Par exemple, la vis de pression comprend un bout sphérique ou un bout plat.

Selon un autre aspect de l'invention, il est également proposé un combineur de puissance comprenant quatre amplificateurs hyperfréquences de puissance à état solide selon l'une des revendications précédentes, reliés en H par un dispositif Té magique.

Ainsi, la disposition en H permet une interconnexion directe des modules d'amplification au système de combinaison sans obligation d'avoir recours à des liaisons guidées limitant ainsi les pertes et améliorant la répartition des points chauds.

Dans un mode de réalisation, les éléments du combineur sont montés à plat.

Cela permet une gestion aisée de l'environnement thermique et de la maintenance, ainsi que d'empiler plusieurs fonctions.

Selon un mode de réalisation, le dispositif Té magique est monobloc (au sens où les transitions ligne vers guide, les tés magiques élémentaires deux vers un du dispositif Té magique, les sections de transformation d'impédance et le coupleur bi-directif sont fusionnés.

Cela permet d'assembler par simple vissage les différents éléments sans pertes, et de réduire les coûts et l'encombrement.

Par exemple, le dispositif Té magique monobloc comprend une bride en S, un coupleur bi-directif, trois tés magiques élémentaires deux vers un, des transitions ligne vers guide et des transitions guide vers liaisons coaxiales.

L'invention sera mieux comprise à l'étude de quelques modes de réalisation décrits à titre d'exemples nullement limitatifs et illustrés par le dessin annexé sur lequel :

[Fig.1] illustre schématiquement un amplificateur de puissance hyperfréquences à état solide, selon l'état de l'art ;

[Fig.2] illustre schématiquement un amplificateur de puissance hyperfréquences à état solide, selon un aspect de l'invention ;

[Fig.3] illustre schématiquement un amplificateur de puissance hyperfréquences à état solide, selon un aspect de l'invention ;

[Fig.4] illustre schématiquement un amplificateur de puissance hyperfréquences à état solide, selon un autre aspect de l'invention ;

[Fig.5] illustre schématiquement un amplificateur de puissance hyperfréquences à état solide, selon un autre aspect de l'invention ;

[Fig.6] illustre schématiquement un amplificateur de puissance hyperfréquences à état solide, selon un autre aspect de l'invention ;

[Fig.7] illustre schématiquement un combineur de puissance, selon un autre aspect de l'invention.

Sur l'ensemble des figures, les éléments ayant des références identiques sont similaires.

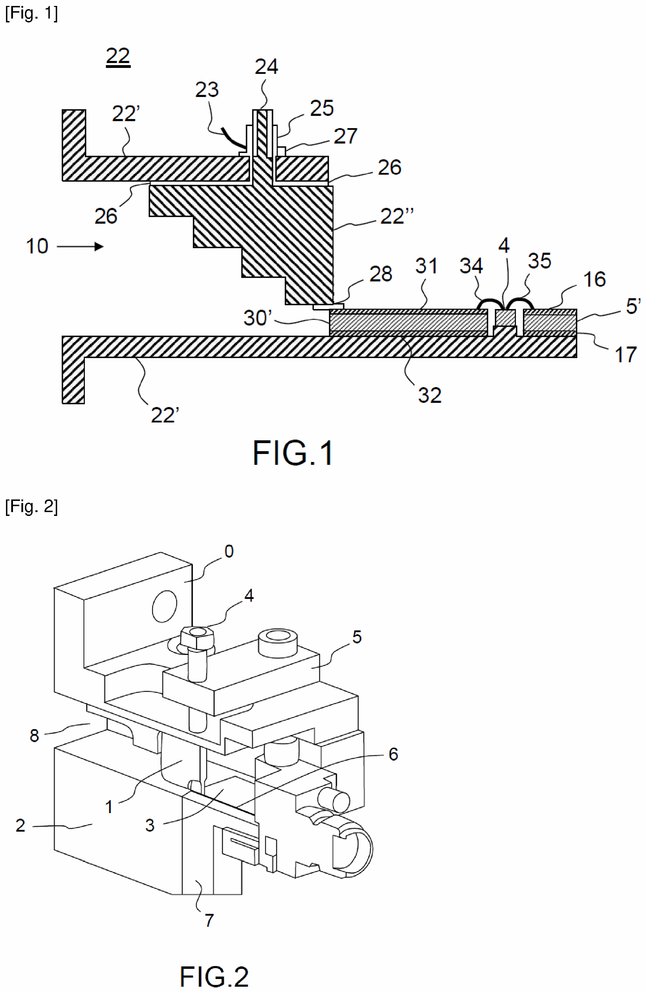

Sur la figure 2 est illustré, selon un aspect de l'invention, un amplificateur de puissance hyperfréquences à état solide.

Contrairement au principe de transition entre une piste faisant office de ligne de propagation et l'arête du guide d'onde décrit sur l'état de l'art de la figure 1, réalisée par une liaison micro-ruban entre l'arête du guide et la micropiste, la présente invention réalise cette transition par un contact direct entre l'arête et la ligne de propagation assuré par un dispositif de serrage, comprenant par exemple au moins une vis de pression.

L'amplificateur de puissance hyperfréquences à état solide comprend une partie supérieure 0 d'un guide d'onde, une arête à transformation d'impédance linéarisée 1, et une partie inférieure 2 du guide d'onde, qui peut, dans certains cas, elle aussi disposer d'une arête à transformation d'impédance linéarisée.

L'amplificateur à état solide comprend un circuit imprimé 3 muni d'une ligne de propagation ou micropiste 6, au moins une vis de pression 4, et un raidisseur 5 support de pression. L'amplificateur comprend également une semelle 7 support et une cavité 8 du guide. Sur les figures, seul un dispositif à une vis de pression 4 est représenté, mais de manière non limitative.

Les amplificateurs à état solide de l'état de l'art utilisent tous des interconnections filaires (liaison ruban), connectorisées (liaison coaxiale) ou rayonnées (antennes).

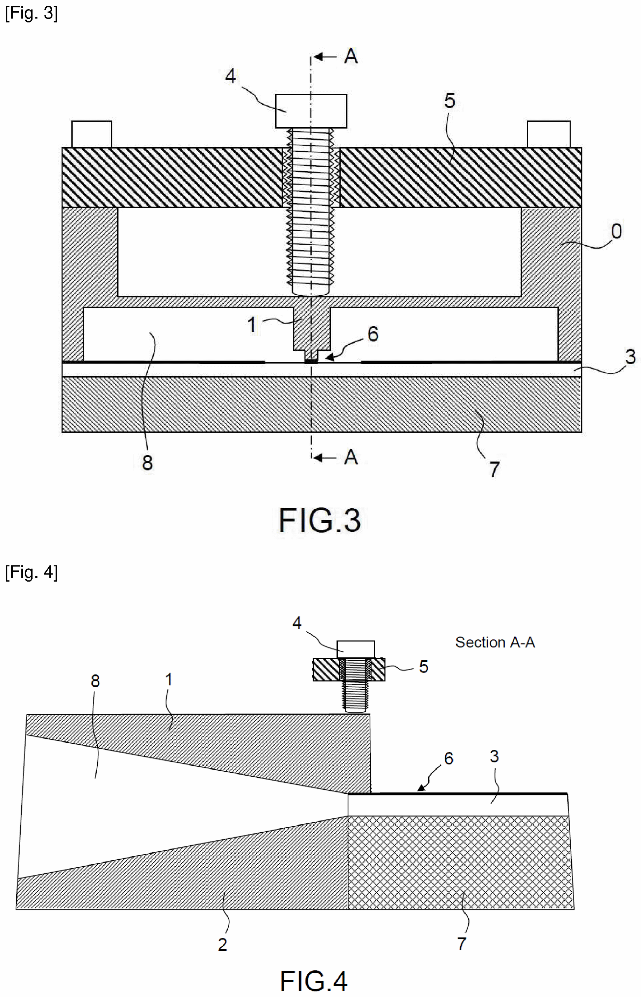

Les figures 3 et 4 représentent des vues de coupe d'un amplificateur à état solide selon un aspect de l'invention, respectivement en vue de face et latérale.

L'objectif de l'amplificateur à état solide de l'invention est de faire transiter un signal électromagnétique d'une ligne de propagation ou micropiste 6 vers une section de guide ou section de la cavité du guide 8.

Cette transmission peut être réalisée en bande étroite au moyen d'une simple arête 1 ou "ridge" en langue anglaise. Pour élargir la bande passante à 6-18GHz, il faut recourir à un système de transformation d'impédance linéarisé double arêtes 3, 6 comme illustré figures 3 et 4. Pour que cette transmission soit efficace, il faut garantir un contact électrique entre l'arête 1 et la micropiste 6.

Or, du fait des tolérances de réalisation et d'assemblage des pièces mécaniques et du circuit imprimé 3 monté sur sa semelle 7 en circuit imprimé (on a donc un circuit imprimé 3 monté sur une semelle en métallique), il subsiste un mince espace résiduel séparant les deux lignes de transmission ou arêtes (arête 1 et micropiste 6) qu'il est nécessaire de combler.

Afin d'assurer le contact électrique sur toute la plage de température (du fait de la prise en compte de effets de dilatation) et durant n'importe quelle utilisation prévue (contraintes de tenue en vibrations et chocs), au moins une vis de pression 4 est ancrée dans un raidisseur 5 support de pression et vient déformer la cavité 8 par appui sur l'arête 1 en restant dans le domaine élastique.

L'appui sur l'arête 1 permet de réaliser le contact entre son extrémité basse et la ligne de propagation ou micropiste 6.

Le bon fonctionnement de l'amplificateur est conditionné par :

- l'appui sur l'arête 1 qui doit être maitrisé et la déformation qui doit être limitée pour ne pas modifier notablement les dimensions de la cavité 8 (impact sur la qualité de la propagation) ;
- le circuit imprimé sur lequel l'arête 1 vient en contact doit être dur et doit présenter une largeur de ligne ou micropiste compatible de la largeur de l'arête à son extrémité ;
- le type de circuit imprimé doit pouvoir passer la puissance escomptée (50W CW) sur toute la plage de températures, allant de -40° à +85°C ;
- le temps de fonctionnement de l'amplificateur à état solide ne doit pas entrainer de dégradation du circuit imprimé, de sorte qu'il reste dans le domaine élastique ;
- la liaison doit pouvoir être montée et démontée sans altérer les performances par simple vissage et dévissage.

De manière préférentielle, le substrat résiste aux déformations sous une pression minimale de 500 MPa, et est en $Al_2O_3$ ou duroid (marque déposée) du type RO4350 ou RO4003, et le couple de serrage de la vis ne doit pas entrainer de déformation irréversible en restant dans la limite du domaine élastique.

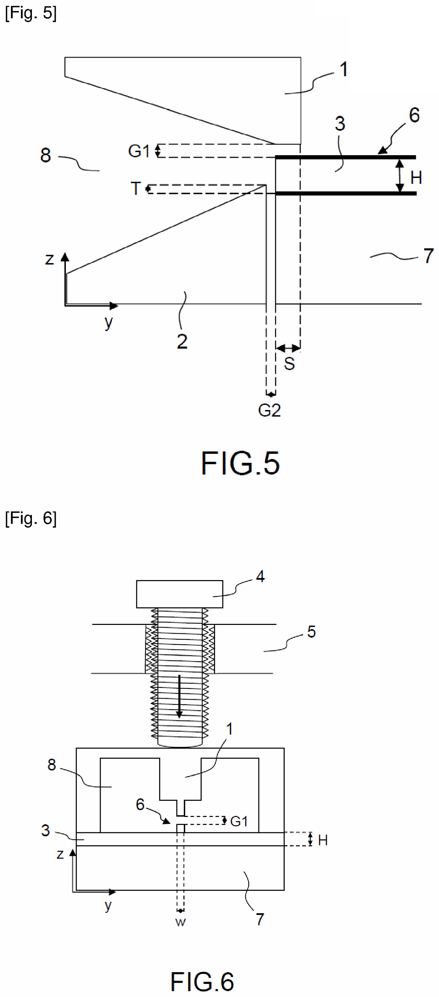

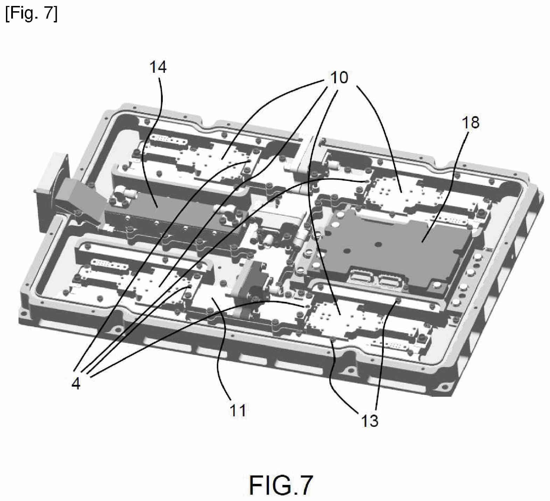

Dans un mode de réalisation préféré, les tolérances mécaniques et tolérances d'assemblage sont compatibles du type de substrat utilisé et donc de sa permittivité diélectrique εr. Par conséquent, la dimension maximale admissible de l'interstice G1, tel qu'illustré sur les figures 5 et 6, est de 0,1mm pour garantir de rester dans le domaine élastique du dispositif de serrage ou clamp. Les tolérances Tx et Tz sont alors inférieures à 0,1mm. L'architecture illustrée sur la figure 7 permet d'amener le circuit imprimé en butée sur la partie inférieure 2 du guide ce qui conduit à avoir G2=0, élément crucial pour le bon fonctionnement hyperfréquence. Ainsi : G1, Tx, Tz et Ty < 0,1mm et G2 = 0.

Comme le montre la figure 5, la tolérance Tz d'alignement en Z entre le guide inférieur 2 et la semelle support 7 reste très inférieure à l'épaisseur H du substrat avec $\frac{H}{T} > 5$.

De la même manière, il est important que la zone d'appui de l'arête 1 soit alignée avec la micropiste comme le montre la figure 6. Aussi, de manière préférentielle, la tolérance Tx d'alignement en x entre l'arête 1 et la micropiste 6 reste très inférieure à la largeur Wr de l'arête 1 au niveau de la zone de contact avec le circuit imprimé ou que la largeur Wl de la micropiste 6 soit plus large que Wr à laquelle est ajoutée la tolérance d'assemblage de 0,1mm. Les simulations impliquent donc qu'il est nécessaire d'avoir :

$$\frac{Wr}{Tx} < 4 \ ou \ Wl > Wr + 0{,}1mm$$

Aussi la valeur cible εr du substrat du circuit imprimé est donnée par la relation suivante :

$$Pour \frac{W}{h} < 1 \qquad Z_0 = \frac{60}{\sqrt{\varepsilon_{eff}}} ln\left(\frac{8h}{W} + \frac{W}{4h}\right)$$

$$\text{Avec}\quad \varepsilon_{eff} = \frac{\varepsilon_r+1}{2} + \frac{\varepsilon_r-1}{2}\left[\left(1+12\frac{h}{W}\right)^{-\frac{1}{2}} + 0{,}04\left(1-\frac{W}{h}\right)^2\right]$$

Aussi, préférentiellement le substrat est à faible perte, i.e. qu'il doit offrir une tangente delta (tan $\delta$) la plus faible possible (classiquement <0.001) pour limiter l'échauffement par pertes linéiques et offrir une excellente conductivité thermique.

Comme illustré sur la figure 7, il est également proposé un combineur de puissance comprenant quatre amplificateurs 10 de puissance hyperfréquence à état solide tels que précédemment décrits, reliés en H par un Té magique 11, dit quatre vers un en topologie en H qui présente la particularité qu'une moitié est fusionnée avec un châssis 12, et que l'autre moitié est assemblée par vissage 13. Le combineur comprend un coupleur bi-directif 14. En outre, la partie supérieure du dispositif combineur et coiffe à la fois la partie inférieure du combineur fusionnée avec le châssis et les quatre modules amplificateurs hyperfréquence à état solide.

Les vis de pression 4 permettent de garantir le contact entre les amplificateurs 10 et les accès du Té magique 11.

La configuration en H du combineur permet une optimisation de la surface d'encombrement ainsi que la répartition des points chauds. Le Té Magique quatre vers un est monobloc (bride en S et coupleur bi-directif 14 sont usinés d'un seul tenant) et intègre des transitions micropiste vers guide double arête avec transformation d'impédance hors standard qui permettent une compacité optimale sans transition. Les pertes sont donc minimes et le rendement maximisé.

Les amplificateurs 10 de puissance hyperfréquences, le dispositif Té magique 11 et le coupleur bi-directif 14 s'assemblent et se démontent très facilement par simple vissage. Les maintenance et réparabilité sont ainsi grandement facilitées.

Les interconnexions du dispositif combineur ne sont pas hyperstatiques.

Le dispositif combineur comprend également un module conducteur ou "driver" en langue anglaise" 18 pour pré-amplifier le signal.

La configuration de montage "à plat" des éléments du dispositif combineur permet une gestion aisée de la thermique. La conception modulaire permet une évolutivité à moindre coût en plus de la maintenabilité aisée.

Le dispositif combineur offre une isolation entre voies qui permet la tenue de performance de la dégradation douce.

Dans cet exemple, le substrat utilisé est une alumine d'épaisseur H=0,6mm et dont la largeur de ligne est WI=0,6mm pour une impédance caractéristique de 50 ohms. Du côté de l'arête en appui, la largeur est Wr=0,4mm et la longueur de recouvrement S=0,8mm.

**Revendications**

1. Amplificateur de puissance hyperfréquences à état solide comprenant une partie supérieure (0) d'un guide d'onde, une arête (1) de guide d'onde à transformation d'impédance linéarisée, une partie inférieure (0) du guide d'onde, une ligne de propagation (6), et au moins une interconnexion, entre la ligne de propagation (6) et l'arête (1) de guide d'onde à transformation d'impédance linéarisée, munie d'un dispositif de serrage (4) garantissant un contact direct entre l'arête (1) et la ligne de propagation (6), dans lequel le dispositif de serrage comprend au moins une vis de pression (4) et un raidisseur (5) support de pression, la vis de pression exerçant une force sur la ligne de propagation (6) via le raidisseur (5) pour maintenir le contact direct.

2. Amplificateur de puissance hyperfréquences à état solide selon la revendication 1, dans lequel la vis de pression (4) comprend un bout sphérique ou un bout plat.

3. Dispositif combineur de puissance comprenant quatre amplificateurs de puissance hyperfréquences à état solide selon l'une des revendications précédentes, reliés en H par un dispositif Té magique (11).

4. Dispositif combineur de puissance selon la revendication 3, dans lequel les éléments sont montés à plat.

5. Dispositif combineur de puissance selon la revendication 3 ou 4, dans lequel le dispositif Té magique (11) est monobloc.

**Patentansprüche**

1. Hyperfrequenz-Festkörperleistungsverstärker, umfassend einen Oberteil (0) eines Wellenleiters, einen linearisierten Impedanztransformations-Wellenleitergrat (1), einen Unterteil (0) des Wellenleiters, eine Ausbreitungsleitung (6), und mindestens eine Vernetzung zwischen der Ausbreitungsleitung (6) und dem linearisierten Impedanztransformations-Wellenleitergrat (1), die mit einer Klemmvorrichtung (4) versehen ist, die einen direkten Kontakt zwischen dem Grat (1) und der Ausbreitungsleitung (6) gewährleistet, wobei die Klemmvorrichtung mindestens eine Druckschraube (4) und eine Druckunterlagenversteifung (5) umfasst, wobei die Druckschraube eine Kraft über die Versteifung (5) auf die Ausbreitungsleitung (6) ausübt, um den direkten Kontakt aufrecht zu erhalten.

2. Hyperfrequenz-Festkörperleistungsverstärker nach Anspruch 1, wobei die Druckschraube (4) ein sphärisches Endstück oder ein flaches Endstück umfasst.

3. Leistungskombinierervorrichtung, umfassend vier Hyperfrequenz-Festkörperleistungsverstärker nach einem der vorstehenden Ansprüche, die durch eine magische T-Vorrichtung (11) H-förmig verbunden sind.

4. Leistungskombinierervorrichtung nach Anspruch 3, wobei die Elemente flach montiert sind.

5. Leistungskombinierervorrichtung nach Anspruch 3 oder 4, wobei die magische-T-Vorrichtung (11) aus einem Stück ist.

**Claims**

1. Solid state hyperfrequency power amplifier comprising an upper part (0) of a waveguide, a linearised impedance transforming waveguide ridge (1), a lower part (0) of the waveguide, a propagation line (6), and at least one interconnection, between the propagation line (6) and the linearised impedance transforming waveguide ridge (1), provided with a clamping device (4) that guarantees direct contact between the ridge (1) and the propagation line (6), wherein the clamping device comprises at least one pressure screw (4) and a pressure support stiffener (5), the pressure screw exerting a force on the propagation line (6) via the stiffener (5) to maintain direct contact.

2. Solid state hyperfrequency power amplifier according to claim 1, wherein the pressure screw (4) comprises a spherical end or a flat end.

3. Power combiner device comprising four solid state hyperfrequency power amplifiers according to any one of the preceding claims, which are connected in an H configuration by a magic T device (11).

4. Power combiner device according to claim 3, wherein the elements are mounted flat.

5. Power combiner device according to claim 3 or 4, wherein the magic T device (11) is in one piece.

[Fig. 1]

FIG.1

[Fig. 2]

FIG.2

[Fig. 3]

FIG.3

[Fig. 4]

FIG.4

[Fig. 5]

FIG.5

[Fig. 6]

FIG.6

[Fig. 7]

FIG.7

**EP 4 165 719 B1**

## RÉFÉRENCES CITÉES DANS LA DESCRIPTION

**Documents brevets cités dans la description**

- EP 2201679 A1
- EP 0074613 A1
- US 4458222 A
- US 10340574 B2